# EUROPEAN PATENT APPLICATION

(11) **EP 3 343 725 A1**
(43) Date of publication of application: **04.07.2018**
(21) Application number: 17210332.7
(22) Date of filing: 22.12.2017
(51) Int. Cl.: H02J 7/00, H02J 7/02, G06F 1/16, H01F 27/02, H01F 27/22, H01Q 1/36, H01Q 1/42

(54) **NON-CONDUCTIVE FRAME COATED WITH CONDUCTIVE LAYER TRANSMITTING ELECTROMAGNETIC WAVES OR HAVING FUNCTION OF HEAT RADIATION**

(30) Priority: 22.12.2016 KR 20160177060
(71) Applicant: Kim, Jae Beom, Seoul 06548 (KR)
(72) Inventor: Kim, Jae Beom, Seoul 06548 (KR)
(74) Representative: Pfenning, Meinig & Partner mbB

(57) **Abstract**

Disclosed herein is a non-conductive frame coated with a conductive layer transmitting electromagnetic waves or having a function of heat radiation including a non-conductive frame functioning as a medium and being used in a device including a wireless electromagnetic wave transmitting module or a wireless electromagnetic wave transmitting or receiving module, and a conductive layer formed on one surface of the non-conductive frame, wherein one or more grooves are formed on at least one area of the conductive layer so as to pass through the at least one area in order to allow the non-conductive frame to be exposed, thereby giving a characteristic of electromagnetic wave transmission, and wherein one or more slits are formed on the non-conductive frame along with the groove.

According to the above-described invention, the non-conductive frame coated with a conductive layer transmitting electromagnetic waves or having a function of heat radiation may have an advantageous effect of being attached to an outer case of diverse devices that is configured of plastic, being equipped inside the device and, most particularly, being capable of enhancing the aesthetic external features of the device by adding a metallic texture when applied to the outer case.

## Description

This application claims the benefit of the Korean Patent Application No. 10-2016-0177060, filed on [December 22, 2016], which is hereby incorporated by reference as if fully set forth herein.

### BACKGROUND OF THE INVENTION

### Field of the Invention

The present invention relates to a non-conductive frame coated with a conductive layer. And, most particularly, the present invention provides a non-conductive frame coated with a conductive layer transmitting electromagnetic waves or having a function of heat radiation, wherein a groove having a predetermined width is formed on a portion of the conductive layer of the non-conductive frame having a conductive layer formed thereon so as to expose the non-conductive frame, or a slit is also formed on the non-conductive frame along with the groove, wherein the film is attached to a case of a device that is related to wireless charging or wireless communication or equipped inside the case, wherein the non-conductive frame is capable of transmitting electromagnetic waves despite the presence of the conductive layer, which has a general function of blocking electromagnetic waves, and wherein a heat radiation function is given to the non-conductive wave due to the conductive layer so as to prevent overheating of an applied device and to allow stable usage of the corresponding device, thereby replacing the carbon group heat radiation element, which corresponds to the related art heat radiation element, or being used as the heat radiation element along with the carbon group heat radiation element.

Additionally, by using the film in a single layer or by layering multiple films in a multi-layer structure, the non-conductive frame may also be used as an antenna for amplifying NFC. And, most particularly, in case of attaching the film according to the present invention to the case of the corresponding device, by providing a metallic texture to the outer case of the device, the enhanced exterior features of the device may be expected.

### Discussion of the Related Art

Recently, the wireless charging technology has evolved at a remarkable rate and is being extensively applied in diverse types of appliances including mobile devices.

Such wireless charging may also be referred to as non-contact charging and may be broadly divided into two different types: a method using electromagnetic induction and a method using magnetic resonance.

The electromagnetic induction type charging technology corresponds to a method of charging batteries by generating an induced current between a charging pad and two coils provided inside a mobile phone. And, the charging method using magnetic resonance corresponds to a method of performing charging by sending out power through the same frequency to a transmitting/receiving end that is located several meters (m) away from the charging system. Herein, as the currently most commonly used technology, since the electromagnetic induction type charging method uses frequencies of several hundreds of kilohertz (kHz), most particularly, this technology may be used to perform wireless charging of mobile phones, which uses frequencies within a range of 100 to 300 kHz, as well as laptop computers and other mobile device. Furthermore, this method may also be used for charging electric mobile vehicles.

Meanwhile, manufacturers of mobile devices, such as mobile phones, have consistently developed their technologies in order to maximize the performance of their mobile devices and, eventually, achieved their goal of realizing a state-of-the-art mobile device technology. Therefore, it has become difficult to find any distinction in device performances between manufacturers.

Accordingly, the manufacturers are becoming more focused on the design of their mobile devices, and, therefore, the selection of the material for a frame configuring the outside feature of the mobile device has become one of the most important issues.

More specifically, until recently, in order to manufacture light-weight mobile devices, the manufacturers have mostly fabricated their mobile devices by using plastic material. However, due to the characteristics of the plastic material, there were limitations in achieving high-quality texture in the mobile devices. Metallic external features may be considered to be one of the most adequate candidate for replacing plastic external features. However, since metal has a tendency to block electromagnetic waves, the usage of metallic outer cases causes problem in performing diverse operations of the wireless transmitting/receiving modules, such as wireless charging as well as near field communication (NFC), and other diverse mobile payment methods.

Therefore, a material that can be used for the outer case of mobile devices as a replacement for plastic in order to further enhance the aesthetic external features of mobile devices is being required. Herein, although metallic substances may replace plastic, it is imperative to develop a technology for creating cases that are not only capable of maintaining lightweight of the device, but also capable of transmitting electromagnetic waves in order to allow the device to be normally operated as a wireless transmitting/receiving module. Furthermore, the need to develop a metallic replacement that can replace the carbon group heat radiation element is also required. Herein, by having such metallic element equipped inside the device, the characteristic of radiating heat may be given to the metallic element within a range of being capable of maintaining the characteristic of transmitting electromagnetic waves.

### SUMMARY OF THE INVENTION

Accordingly, the present invention is directed to a non-conductive frame coated with a conductive layer transmitting electromagnetic waves or having a function of heat radiation that substantially obviate one or more problems due to limitations and disadvantages of the related art.

A technical object of the present invention is to provide a technical object of the present invention is to provide a non-conductive frame coated with a conductive layer transmitting electromagnetic waves or having a function of heat radiation that can be attached to an outer case of diverse devices that is configured of plastic and that can be equipped inside the device and, most particularly, that can enhance the aesthetic external features of the device by adding a metallic texture when applied to the outer case.

Another object of the present invention is to provide a non-conductive frame coated with a conductive layer transmitting electromagnetic waves or having a function of heat radiation that can eliminate the function of blocking electromagnetic waves of metal by providing a groove or slit on at least a portion of the conductive layer and that can, therefore, maintain the functions of wireless charging, close-range wireless communication (also referred to as near field communication (NFC)), mobile payment, and so on, which correspond to the unique functions of the device.

Yet another object of the present invention is to provide a non-conductive frame coated with a conductive layer transmitting electromagnetic waves or having a function of heat radiation that can maintain its lightweight by maintaining the usage of its outer case, which is configured of plastic.

Yet another object of the present invention is to provide a non-conductive frame coated with a conductive layer transmitting electromagnetic waves or having a function of heat radiation that can add diversity in colors that are recognized through the groove or slit formed on the frame, by layering a plurality of frames one over another and by applying different colors to each of the conductive layers and/or conductive frames. Thus, the aesthetic external features of the device may be enhanced.

Yet another object of the present invention is to provide a non-conductive frame coated with a conductive layer transmitting electromagnetic waves or having a function of heat radiation that can maximize heat radiation efficiency of the device by using the non-conductive frame coated with a conductive layer as a heat radiation means, wherein the non-conductive frame may be used as a replacement for a graphite heat radiation element, which corresponds to the related art heat radiation means, or wherein the non-conductive frame may be used in combination with the graphite heat radiation element.

A further object of the present invention is to provide a non-conductive frame coated with a conductive layer transmitting electromagnetic waves or having a function of heat radiation that can enhance the performance of an NFC module and an installation device by amplifying (or increasing) the transmission/reception rate of the NFC module, since the multi-layer structure of the non-conductive frame performs the function of an antenna, in case the non-conductive frame coated with a conductive layer is layered in a multi-layer structure.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, according to an exemplary embodiment of the present invention, provided herein is a non-conductive frame coated with a conductive layer transmitting electromagnetic waves or having a function of heat radiation, including a non-conductive frame being used in a device including a wireless electromagnetic wave transmitting module or a wireless electromagnetic wave receiving module, and a conductive layer formed on one surface of the non-conductive frame, wherein one or more grooves are formed on at least one area of the conductive layer so as to pass through the at least one area in order to allow the non-conductive frame to be exposed, thereby giving a characteristic of electromagnetic wave transmission, and wherein one or more slits are formed on the non-conductive frame along with the groove.

Preferably, boundaries of the one or more grooves or slits may be formed in one of straight lines, curved lines, and curled lines.

Preferably, the one or more slits may be extended to form patterns consisting of one of straight lines, curved lines, and curled lines.

Preferably, the frame may be formed or processed by using at least of one of 3D printing, laser processing, cutting, and etching, and the one or more slits are formed or processed by using at least one of 3D printing, sawing, laser processing, punching, and etching.

Preferably, the conductive layer may be formed by using at least one of 3D printing, plating, coating, printing, vacuum evaporation, and adhesion.

Preferably, the conductive layer may be formed by using at least one method of 3D printing, plating, coating, printing, vacuum evaporation, and adhesion.

Preferably, the non-conductive frame coated with a conductive layer may be installed at a position corresponding to a main transmitting direction or a main receiving direction of a transmitting unit or receiving unit of wireless power or wireless charging included in the device.

Preferably, a plurality of non-conductive frames coated with a conductive layer may be layered in a multi-layer structure on a near field communication (NFC) module included in the device.

Preferably, the non-conductive frame coated with a conductive layer may replace a carbon group heat radiation element, which is formed in the device, or may be layered with the carbon group heat radiation element.

Preferably, the plurality of non-conductive frames coated with a conductive layer may be layered so that positions of the grooves or slits are vertically identical to one another, or that positions of the grooves or slits are alternated.

Preferably, a plurality of non-conductive frames coated with a conductive layer may be layered one over another, and wherein a color of a lower frame is recognized through one or more grooves or slits of an upper frame.

Preferably, a lower conductive layer and an upper conductive layer may be configured to have different colors so that the color of the lower conductive layer is recognized through one or more grooves or slits of the upper conductive layer.

Preferably, a lower non-conductive frame and an upper non-conductive frame may be configured to have different colors so that the color of the lower non-conductive frame is recognized through one or more grooves or slits of the upper non-conductive frame.

Preferably, a plurality of non-conductive frames coated with a conductive layer may be layered one over another, and an insulating layer may be further included between each non-conductive frame. Herein, the insulating layer may correspond to any one of air, a film, and a coating layer.

Preferably, the insulating layer and the upper frame may be configured to have different colors so that the color of the insulating layer is recognized through one or more grooves or slits of the upper film.

Preferably, when a plurality of non-conductive frame coated with a conductive layer are layered one over another, patterns of a lower film may be configured to not overlap with an upper film, thereby allowing one or more grooves or slits formed on the lower film to be hidden.

Preferably, the non-conductive frame coated with a conductive layer may be connected to a substrate so as to be applied to a mobile device and used as an antenna.

Preferably, an average width of a groove or slit may be equal to or less than 2 times an average width between two adjacent grooves or slits.

Preferably, the groove or slit may have a width exceeding 0 and less than or equal to several millimeters (mm).

Preferably, an area where the one or more slits are formed may be larger than an area occupied by a wireless transmitting/receiving module for transmitting electromagnetic waves, and an entire area occupied by the wireless transmitting/receiving module may be positioned to overlap with at least a portion of the area where the one or more slits are formed.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIG. 1 illustrates a perspective view showing a non-conductive frame coated with a conductive layer according to a preferred embodiment of the present invention.
FIG. 2 illustrates a detailed view showing a conductive layer according to a preferred embodiment of the present invention.
FIG. 3 illustrates a detailed view showing a groove or slit according to a preferred embodiment of the present invention.
FIG. 4 illustrates a detailed view showing examples of one or more grooves or slits according to a preferred embodiment of the present invention.
FIG. 5 illustrates a detailed view showing examples of an edge of a groove or slit according to a preferred embodiment of the present invention.
FIG. 6 illustrates cross-sectional views each showing an example of a non-conductive frame coated with a conductive layer according to a preferred embodiment of the present invention.
FIG. 7 illustrates a cross-sectional view showing another example of a non-conductive frame coated with a conductive layer according to a preferred embodiment of the present invention.
FIG. 8 illustrates cross-sectionals view showing yet another example of a non-conductive frame coated with a conductive layer according to a preferred embodiment of the present invention.
FIG. 9 illustrates a graph showing measurements of a heat radiation characteristic respective to slit distances of a metal frame by using a time function according to a preferred embodiment of the present invention.
FIG. 10 illustrates a cross-sectional view showing another example of a non-conductive frame coated with a conductive layer according to a preferred embodiment of the present invention.
FIG. 11 illustrates a perspective view and a plane view showing a layered status during a process of forming a groove 105 of a non-conductive frame coated with a conductive layer according to a preferred embodiment of the present invention.
FIG. 12 illustrates a perspective view and a plane view showing a layered status during a process of forming a slit 106 of a non-conductive frame coated with a conductive layer according to a preferred embodiment of the present invention.
FIG. 13 illustrates a detailed view showing an exemplary comparison of overlapping status between an area of a non-conductive frame coated with a conductive layer and an area occupied by a module according to a preferred embodiment of the present invention.

### DETAILED DESCRIPTION OF THE INVENTION

Hereinafter, the exemplary embodiments of the present invention will be illustrated in the appended drawings and described in detail in the detailed description of the present invention. In describing the present invention, when it is determined that the detailed description on a related disclosed technology may cause ambiguity in the concept (or idea) of the present invention, the detailed description of the same will be omitted for simplicity.

The terms used in the description of the present invention are defined based on their corresponding functions within the present invention. And, since the meaning of such terms may vary in accordance with the intentions or practices of anyone skilled in the art, the definition of the terms used in the description of the present invention should be understood based on the overall context of this specification.

In the present invention, although a mobile phone, which corresponds to a mobile device, is described as a main exemplary embodiment of the device adopting the non-conductive frame coated with a conductive layer, the present invention will not be limited only to this. And, therefore, the present invention may also include laptop computers, wearable devices, wireless chargers, and so on. Additionally, by extending its scope of application, the present invention may also be applied to built-in charging devices, and other non-mobile devices, such as electric appliances. More specifically, since the present invention may be applied to any device being equipped with a function of radiating heat or a function of transmitting electromagnetic waves, there is no particular limitation in the types of devices to which the present invention may be applied.

Additionally, the area where the non-conductive frame coated with a conductive layer is formed will not be limited only to a case of the corresponding device. And, therefore, the non-conductive frame according to the present invention may also be equipped inside the corresponding device. Moreover, the texture of the conductive layer will not be separately limited.

Additionally, a conductive layer mainly refers to an electroconductive layer and may also have thermal conductivity. Also, the conductive layer may not be configured only of a 100% metallic substance, which has a function of transmitting electromagnetic waves or a function of radiating heat. In the description of the present invention, it will be preferable to interpret that the conductive layer includes metal as its main substance.

Additionally, the characteristic that the conductive layer includes metal as its main substance indicates that metal occupies the highest portion as compared to other substances configuring the conductive layer.

The conductive layer may be formed of substances having diverse properties, such as paste, liquid, and so on.

Moreover, although a two-dimensional (2D) plate may be generally selected as the shape of the non-conductive frame coated with a conductive layer, it will be apparent that the shape of the non-conductive frame coated with a conductive layer according to the present invention will not be limited only to the two-dimensional or plate shape.

Additionally, in the description of the present invention, a groove 105 refers to a space that is formed by a partial loss of the conductive layer in a state where the non-conductive frame remains, and a slit refers to a gap (or crack), which is formed on an object and through which light can be passed. In other words, the slit refers to a gap (or crack) formed on the non-conductive frame coated with a conductive layer.

Herein, several nanometers, several micrometers, several millimeters, and so on, respectively refer to a range starting from 1 or more to less than 10 nanometers, a range starting from 1 or more to less than 10 micrometers, a range starting from 1 or more to less than 10 millimeters, and so on. Also, several tens of nanometers, several tens of micrometers, several tens of millimeters, and so on, respectively refer to a range starting from 10 or more to less than 100 nanometers, a range starting from 10 or more to less than 100 micrometers, a range starting from 10 or more to less than 100 millimeters, and so on. Furthermore, a sub-nanometer, a sub-micrometer, a sub-millimeter, and so on, respectively refer to a range starting from 0.1 or more to less than 1 nanometer, a range starting from 0.1 or more to less than 1 micrometer, a range starting from 0.1 or more to less than 1 millimeter, and so on.

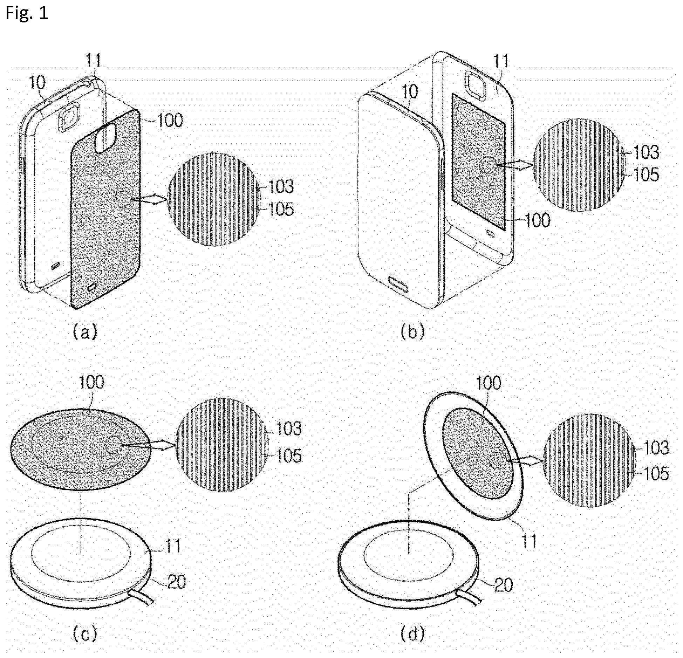

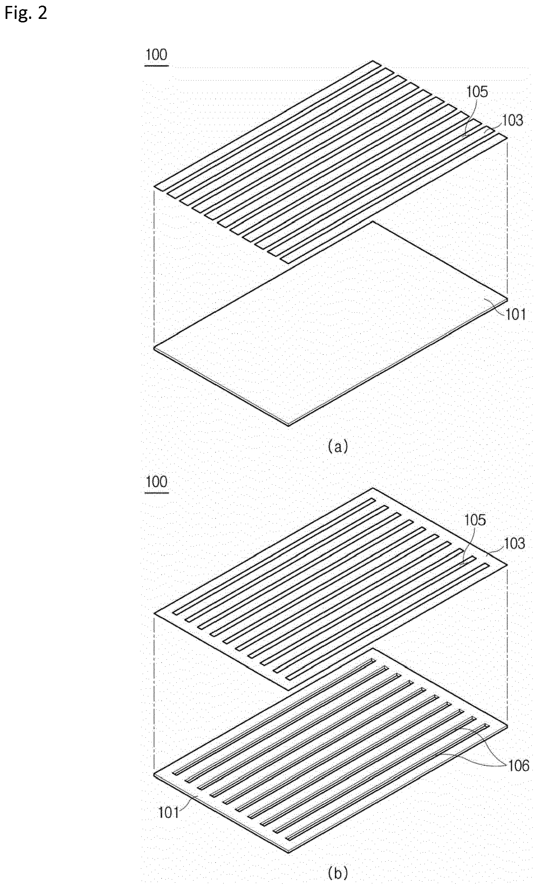

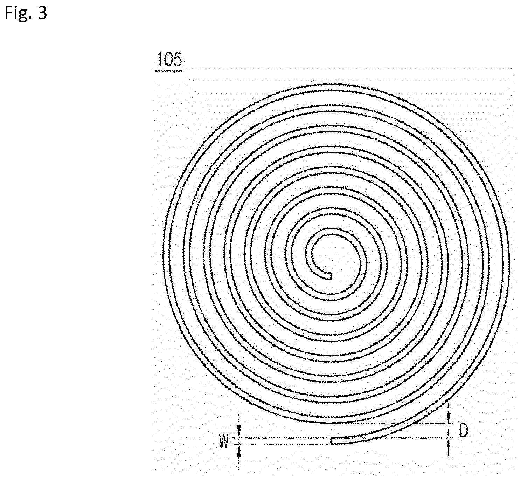

FIG. 1 illustrates a perspective view showing a non-conductive frame coated with a conductive layer according to a preferred embodiment of the present invention. FIG. 2 illustrates a detailed view showing a conductive layer. And, FIG. 3 illustrates a detailed view showing a groove or slit.

As shown in the drawings, in case the non-conductive frame coated with a conductive layer 100 is attached to an outer plastic case 11 of a mobile device 10 or a wireless charger 20, this may add the visual effect of metallic texture and may also enhance the aesthetic external features of the non-conductive frame coated with a conductive layer 100. However, as described above, the non-conductive frame coated with a conductive layer 100 may not only be applied to the exterior of the device but may also be applied to the interior of the device without limitation.

Herein, one or more grooves 105 or one or more slits 106 along with the one or more grooves 105 may be formed in other parts excluding the conductive layer (as shown in a and b of FIG. 2).

The above-described non-conductive frame coated with a conductive layer 100 may be configured by having one surface of a non-conductive frame 101 attached to the mobile device 10 and by having a conductive layer 103 formed on another surface of the non-conductive frame 101.

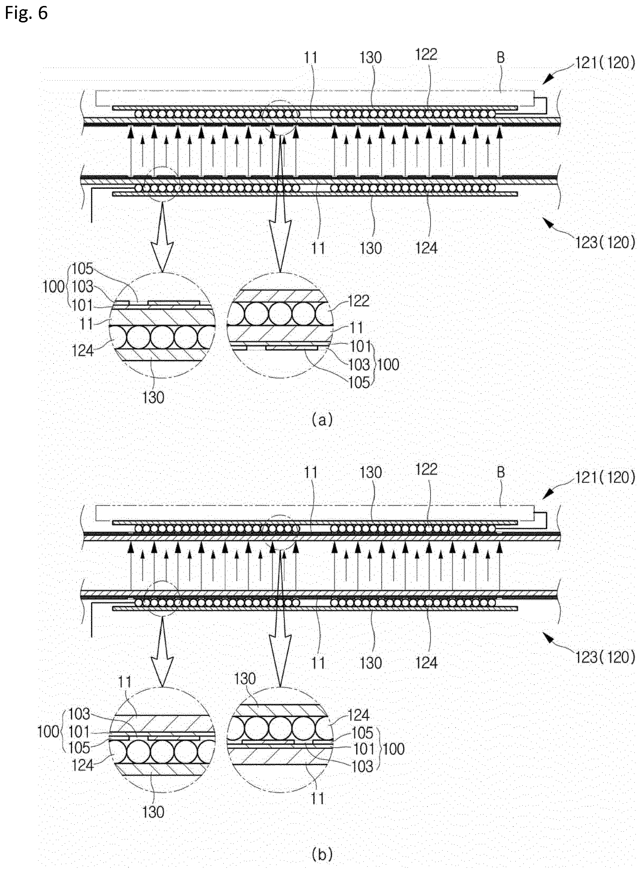

Herein, it is preferable that the non-conductive frame 101 is configured of a polymer. And, in case the non-conductive frame 101 is applied to the exterior of the case 10, the non-conductive frame 101 may be directly attached to the case 10 or may be attached to the case10 by using an insulating layer 110 as a medium, as shown in FIG. 6. Also, the non-conductive frame 101 may be configured of a colored or colorless transparent or non-transparent material.

The conductive layer 103 is formed on the non-conductive frame 101 by using at least one method selected from 3D printing, plating, coating, printing, vacuum evaporation, and adhesion of metal films, and so on. However, the method for forming the above-described conductive layer will not be limited only to the examples listed above.

In order to add the characteristics of heat radiation or electromagnetic wave transmission to the conductive layer 103, one or more grooves 105 or one or more slits 106 along with the one or more grooves 105 are formed on at least an area of the conductive layer 103. And, by having the groove 105 pass through the conductive layer 103, the non-conductive frame 101 may be exposed. The groove 105 may be formed on the conductive layer 103 according to predetermined patterns or may be formed by processing a surface of the conductive layer 103 having no patterns. Additionally, the slit 106 may be formed by processing the non-conductive frame 101, or the slit 106 may be formed at the same time as the non-conductive frame 101.

More specifically, the groove 105 may be formed or processed by using at least one method selected from 3D printing, laser processing, cutting, and etching. And, the slit 106 may be formed or processed by using at least one method selected from 3D printing, sawing, laser processing, punching, and etching.

Although it is preferable that the groove 105 and the slit 106 has a width (W) greater than 0 and less than or equal to several millimeters (mm), the range of the width may be expanded within a range of maintaining the characteristics of electromagnetic wave transmission or heat radiation. Furthermore, in order to ensure the beauty of the exterior of the frame, the range of the width may be limited to a predetermined range. Nevertheless, if the width is formed outside of the above-mentioned range, although there is no significant change in the characteristic of electromagnetic wave transmission, the characteristics of heat radiation may be degraded.

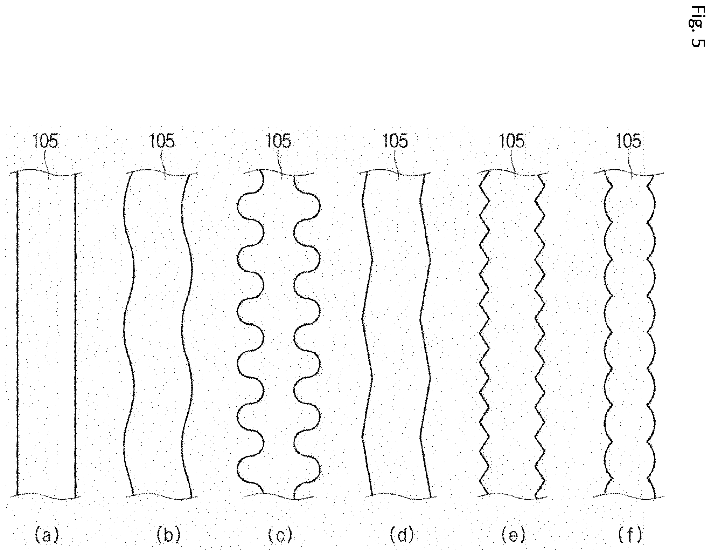

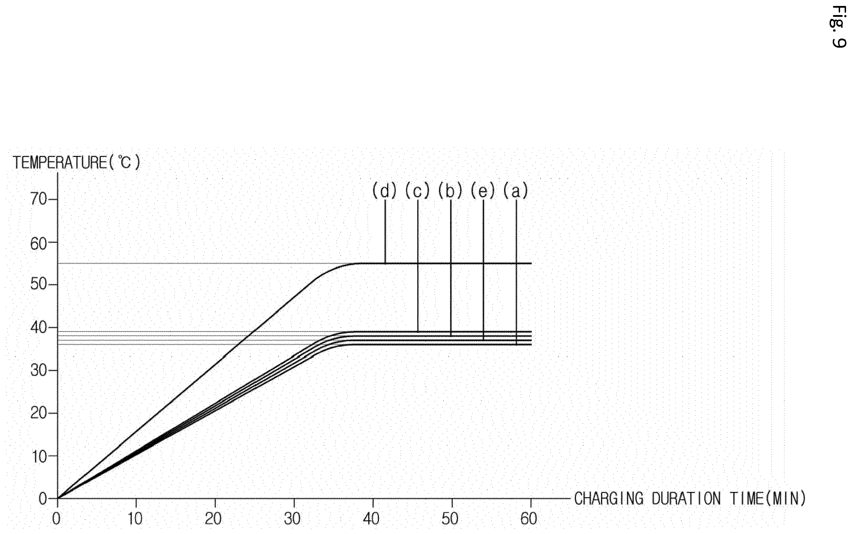

The wireless transmitting/receiving module 120 may correspond to a receiving unit for wireless charging 121, as shown in FIG. 5 and FIG. 9, and, evidently, the transmitting unit 123 may correspond to an NFC module 125, an MST module 127, which is used as a means of mobile payment, such as Samsung Pay, and so on.

Additionally, when deciding the width of the groove 105 or the slit 106, the aesthetic external features may also be an issue that should be taken into consideration. In case the width of the groove 105 or the slit 106 becomes excessively large to be recognized by the naked human eye, the characteristics of electromagnetic wave transmission or heat radiation may become a separate issue, since the aesthetic external features become significantly degraded. Therefore, such features should be taken into consideration when deciding the width of the groove or slit.

In other words, since the groove 105 or slit 106 that is formed to have a width ranging from sub-nanometer units to several tens of micrometer units is not easily recognized by the naked human eye, and since such groove 105 or slit 106 has no significant difference as compared to the non-conductive frame coated with a conductive layer 100, which does not have any groove 105 or slit 106 formed thereon, if a non-conductive frame coated with a conductive layer 100 having a texture that is very similar to a non-conductive frame coated with a conductive layer 100 having no groove 105 or slit 106 formed thereon is wanted, it is preferable to limit the width of the groove 105 or slit 106 to the above-described range. And, in this case, the width of the groove 105 or slit 106 has a critical significance.

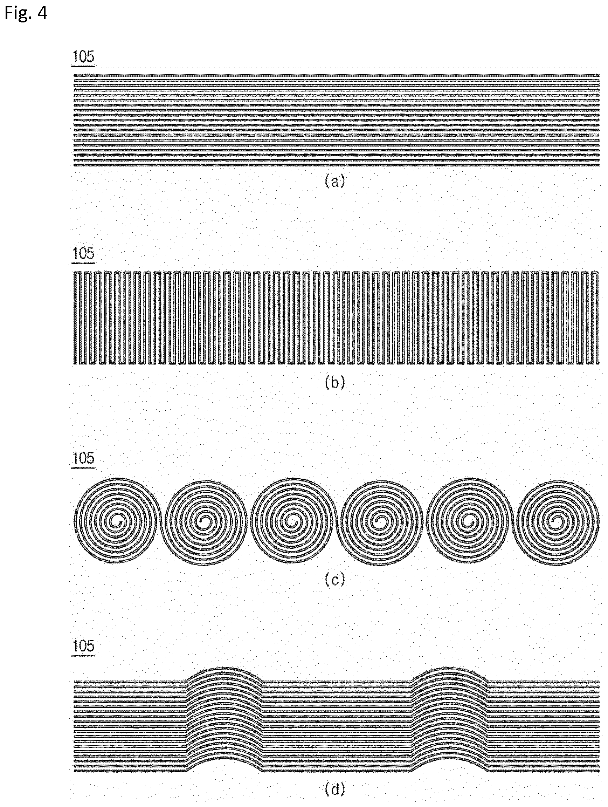

As shown in FIG. 4, the groove 105 or slit 106 may show patterns formed in straight lines (FIG. 4a), curved lines (FIG. 4b), and curled lines (FIG. 4c). Alternatively, the groove 105 or slit 106 may also show patterns formed of a combination of any two of the above-described patterns (FIG. 4d). Also, as shown in FIG. 5, the boundary between the groove 105 and the conductive layer 103 or the boundary between the slit 106 and the conductive layer 103 may show single-shaped patterns formed in straight lines, curved lines, curled lines(spiral lines), an uneven structure(a bulgy-and-hollow structure), and so on, or combined patterns configured of a random combination of any two of the above-described patterns.

For example, in case of forming a slit by using the punching process, if the punching process is continuously performed so that the holes formed by each punching process can overlap one another, the boundary of the slit 106 forms a shape shown in FIG. 5f.

At this point, as shown in FIG. 3, it is preferable that an average value of the width (W) of the groove 105 or slit 106 is less than or equal to 2 times the average value of a distance (D) between two neighboring grooves 105 or slits 106. And, in this case, electromagnetic waves may be easily transmitted by passing through the conductive layer.

The above-described slit 106 may be formed on the entire conductive layer or a part of the conductive layer. And, more specifically, as shown in FIG. 6, the slit 106 may be partially formed on an area corresponding to a position of the wireless transmitting/receiving module 120.

This will hereinafter be described in more detail.

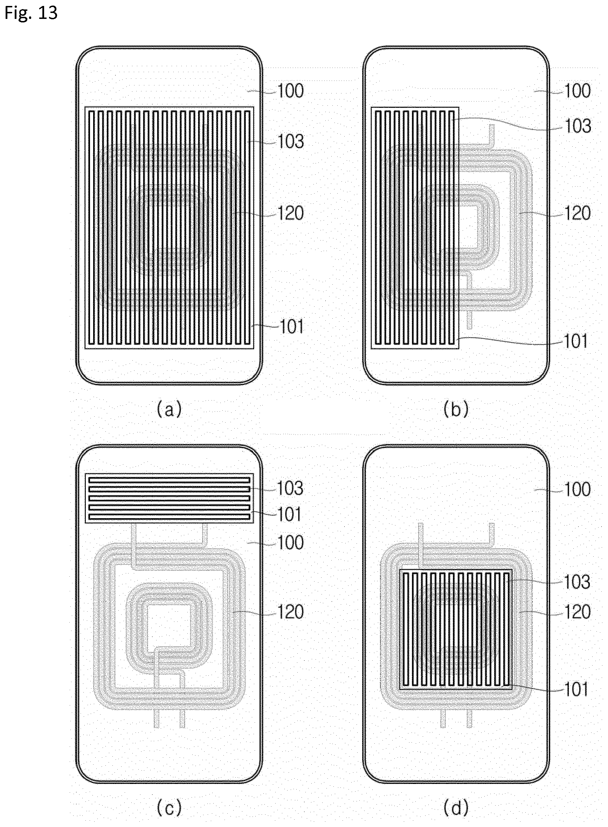

The areas where the above-described grooves 105 or slits 106 are formed may be applied throughout the entire frame 100. However, when required, the grooves 105 or slits 106 may be partially formed on an area corresponding to an area where the wireless transmitting/receiving module 120 is provided. However, the area where the grooves 105 or slits 106 are formed should be larger than the area occupied by the wireless transmitting/receiving module 120, as shown below in FIG. 13. Herein, (a) of FIG. 13 illustrates a preferred embodiment of the present invention, wherein the overall area of the wireless transmitting/receiving module 120 is overlapped by a groove 105 or slit 106 area that is larger than the overall area of the wireless transmitting/receiving module 120, and (b) to (d) of FIG. 13 illustrate non-preferred embodiments of the present invention. More specifically, (b) corresponds to a case when the groove 105 or slit 106 area is positioned to overlap only a part of the module 120, (c) corresponds to a case when the groove 105 or slit 106 area is positioned to not overlap the module 120 at all, and (d) corresponds to a case when the groove 105 or slit 106 area is smaller than the area of the module 120. Since an eddy current occurs in all of the above-described cases, none of the above-described cases (b) to (d) is preferable for the transmission of electromagnetic waves. In other words, referring to FIG. 13(a), in case of forming a virtual edge on an outermost edge of the area where the grooves 105 or slits 106 are formed, this indicates that the wireless transmitting/receiving module 120 should be located within the virtual edge.

Herein, it will be apparent that the patterns of the slit 106 shown in FIG. 13(a) are not limited only to the patterns shown in FIG. 13(a). Most particularly, the area where the grooves 105 or slits 106 are formed should be larger than the area occupied by the wireless transmitting/receiving module 120 for transmitting electromagnetic waves, and the overall area occupied by the wireless transmitting/receiving module 120 should be positioned within at least a part of the area where the grooves 105 or slits 106 are formed (so as to be covered and/or overlapped by the corresponding area). If the area where the grooves 105 or slits 106 are formed overlaps only a part of the area occupied by the module 120 or does not overlap at all the area occupied by the module 120, or in case the area occupied by the module 120 is smaller than the area where the grooves 105 or slits 106 are formed, an eddy current may be generated during the process of transmitting the electromagnetic waves. And, accordingly, since the transmission of the electromagnetic waves is not performed easily, in case of communication, transmission/reception sensitivity may be degraded, or, in case of wireless charging, the duration of the charging time may be extended. For example, in case of a disclosed slot antenna, an eddy current may be generated within a slot of a metal plate, wherein the slot is formed on the metal plate due to the electromagnetic waves that are emitted from an electromagnetic wave emitting module. And, a magnetic flux within the slot may be increased by using the generated eddy current. Thus, due to the magnetic flux of the metal plate itself, the metal plate having a slot formed thereon may be capable of performing the function of an antenna having diverse capabilities (http://central.oak.go.kr/journallist/journaldetail.do;jsessionid=E4FE5E83B5B811E6E3025 D752C9557C7?article_seq=14937&tabname=abst&resource_seq=-1&keywords=null). However, instead of actively performing a specific function (e.g., antenna function) associated with the transmission and/or reception of electromagnetic waves, such as the slot antenna, since the non-conductive frame having the grooves 105 or slits 106 formed thereon does not perform any function associated with the transmission and/or reception of electromagnetic waves, it may be said that the two technologies are not correlated to one another. Therefore, the slot antenna should not be identified as the present invention, and the slot antenna should not be considered to be within the same or similar technical scope of the present invention. In other words, the slot antenna should be considered as a completely different technology. Herein, the term "overlapping" indicates that the slit area of the metal frame is positioned to be above the area occupied by the module at a predetermined distance.

FIG. 6 illustrates cross-sectional views each showing an example of a non-conductive frame coated with a conductive layer according to a preferred embodiment of the present invention.

As shown in the drawing, for example, the non-conductive frame coated with a conductive layer 100 may be attached to a position of the outer case 11 corresponding to positions where a receiver 121 and a transmitter 123 for wireless charging included in the wireless transmitting/receiving module 120 exist. In the present invention, the non-conductive frame coated with a conductive layer 100 is attached to the outer case 11 of a mobile device, and the temperature is measured while charging the mobile device. The charging is carried out for 5 minutes.

As a result, the case 11 that is attached to the non-conductive frame coated with a conductive layer 100 marked a temperature of approximately 55 degrees Celsius (55°C), which indicates that there is no problem in the durability of wireless charging.

According to the above-described result, it is apparent that the non-conductive frame coated with a conductive layer 100 has an excellent heat radiation characteristic.

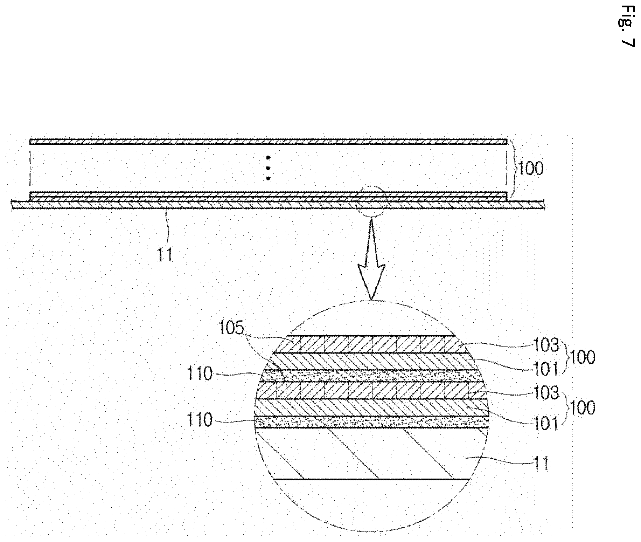

The above-described non-conductive frame coated with a conductive layer 100 may be attached to the case 11 as a single layer or may be attached to the case 11 in a multi-layer structure, as shown in FIG. 7. This will hereinafter be described in more detail with reference to the accompanying drawing. The exemplary embodiment of the multilayered adhesion (or attachment) of the non-conductive frame coated with a conductive layer 100 is also not limited only to the exterior of the case but may also be equally applied to the interior of the case.

FIG. 7 illustrates a cross-sectional view showing another example of a non-conductive frame coated with a conductive layer according to a preferred embodiment of the present invention.

As shown in the drawing, the non-conductive frame coated with a conductive layer 100 according to the present invention is layered in a multi-layer structure. Herein, each layer of the non-conductive frame coated with a conductive layer 100 is given a different color. Thereafter, if the one or more grooves 105 or slits 106 formed on each of an upper film and a lower film are positioned so that they do not overlap one another, the color of the lower film may be faintly recognized through the groove 105 or slit 106 of the upper film. And, by using this method, diverse colors may be implemented by the multilayered structure of the non-conductive frames coated with a conductive layer 100.

Additionally, the non-conductive frame coated with a conductive layer 100 may be layered on the case 11. Herein, the layering may be performed by using an insulating layer 110 as a medium. The insulating layer 110 may corresponds to any one of a means of adhesion, a film, and a coating layer given a predetermined color. Accordingly, the color of the lower insulating layer 110 may be revealed through the groove 105 or slit 106 of the upper non-conductive frame coated with a conductive layer 100. Herein, the insulating layer 110 is merely used as a means for revealing its color.

Meanwhile, when layering non-conductive frames coated with a conductive layer 100 one over another, in case the groove 105 or slit 106 of the upper film does not overlap with the groove 105 or slit 106 of the lower film do not overlap one another at all, the groove 105 or slit 106 of the lower film may be completely hidden. At this point, the aesthetic external features that can be obtained from the non-conductive frame coated with a conductive layer 100 may be adjusted. In this case, there is no change in the characteristic of electromagnetic wave transmission of the non-conductive frame coated with a conductive layer 100.

Additionally, the non-conductive frame coated with a conductive layer 100 according to the present invention may also exist as a means for radiating heat that is generated from the wireless transmitting/receiving module 120.

In order to examine the heat radiation characteristic of the non-conductive frame coated with a conductive layer 100, the non-conductive frame coated with a conductive layer 100 being processed to have one or more grooves 105 or one or more grooves 105 and slits 106 formed thereon is applied to the outer case of the mobile device. Thereafter, when wireless charging is carried out, the measured temperature is examined. The charging is carried out for approximately 1 hour.

As a result, at the point when 40 minutes is passed, the outer case of the device according to the present invention marks a temperature range of approximately 36 to 39°C, which indicates that there is no problem in the durability of wireless charging. Generally, in case the temperature being measured from the outer case of the corresponding device during wireless charging is equal to 45°C or below, it is understood that there is no significant problem. Accordingly, the non-conductive frame coated with a conductive layer 100 according to the present invention has no default in being applied to the outer case of a wireless charging device or a mobile device, and so on.

Due to its excellent thermal conductivity, metal may be the most preferable heat radiation material. However, when metal is applied to the wireless transmitting/receiving module 120, a problem of blocking the electromagnetic waves may occur. Accordingly, as long as the metallic substance blocks the electromagnetic waves, metal cannot be used as a heat radiation material of the device having the function of transmitting or receiving electromagnetic waves. Therefore, instead of using metal, heat radiation elements of the carbon group and, most particularly, graphite 130 has been generally used as the heat radiation means of the wireless transmitting/receiving module 120.

However, since grooves 105 or slits 106 are provided on the non-conductive frame coated with a conductive layer 100, even if the conductive layer 103 is mainly configured of a metallic substance, the electromagnetic waves may be transmitted by passing through the grooves 105 or slits 106, the conductive layer 103 may also be applied as the means of heat radiation of the wireless transmitting/receiving module 120.

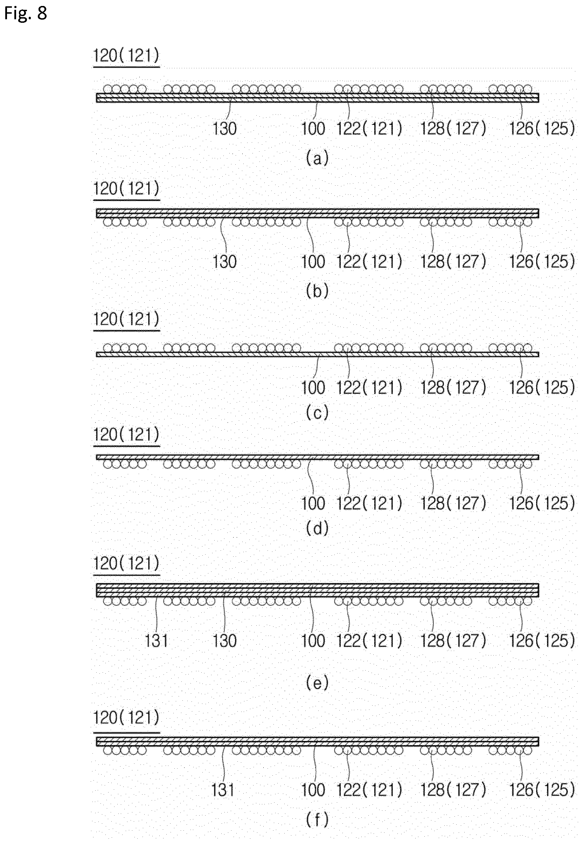

In this case, as shown in FIG. 8a and b, the non-conductive frame coated with a conductive layer 100 may be layered along with the graphite 130. Alternatively, as shown in FIG. 8c and d, the non-conductive frame coated with a conductive layer 100 may also be used by replacing the graphite 130. Herein, graphite corresponds to a carbon group substance, and, therefore, it will be apparent that the graphite may also be replaced with any other substance belonging to the carbon group.

Moreover, a magnetic sheet 131 may be further deposited on the wireless transmitting/receiving module 120. And, therefore, the magnetic sheet 131 may be used by being layered with the non-conductive frame coated with a conductive layer 100, or the magnetic sheet 131 may be used by being layered with the non-conductive frame coated with a conductive layer 100 and the graphite 130 heat radiation element. In this case, the layering order of the magnetic sheet 131, the non-conductive frame coated with a conductive layer 100, and the graphite 130 heat radiation element may include all number of cases. Herein, the magnetic sheet 131 performs the same function as the conventional wireless transmitting/receiving module.

Meanwhile, in case the graphite 130 is layered with the non-conductive frame coated with a conductive layer 100 according to the present invention, the following effects may be expected. More specifically, graphite 130 corresponds to a plate shaped crystal structure. However, since its interlayer binding force is weak, although graphite has an excellent thermal transmission characteristic along a two-dimensional horizontal direction, its vertical thermal transmission characteristic is very weak. However, since the conductive layer 103, which is formed on the non-conductive frame coated with a conductive layer 100 according to the present invention, corresponds to a conductive layer, its thermal transmission characteristic along the vertical direction is excellent. Therefore, the conductive layer 130 may compliment the disadvantages in thermal transmission characteristic of graphite 130.

At this point, although graphite 130 may be coated on the conductive layer 103, the conductive layer 103 may be coated on the graphite 130. In case the conductive layer 103 is coated on the graphite 130, the graphite 130 may replace the non-conductive frame 101.

In FIG. 9, non-conductive frames coated with a conductive layer 100 each having a groove 105 or slit 106 width of 0.01mm (a), 1mm (b), 10mm (c), and 15mm (d) are respectively shown in the form of a temperature function with respect to time, and each temperature function is indicated in comparison with graphite, which corresponds to the standard material.

As shown in the drawing, in case the width of the groove 105 or slit 106 is equal to 15mm, its saturation temperature marks the highest level of approximately 45°C. Accordingly, it can be understood that its heat radiation characteristic is lower than the cases when the width of the groove 105 or slit 106 is equal to 0.01mm, 1mm, and 10mm. Meanwhile, in case the width of the groove 105 or slit 106 is equal to 0.01mm, 1mm, and 10mm, the heat radiation characteristics are similar to the heat radiation characteristic of graphite. Herein, although the case when the width of the groove 105 or slit 106 is equal to 10mm indicates the relatively highest level, it can be understood that its heat radiation characteristic marks a valid level. Therefore, it can be understood that the non-conductive frame coated with a conductive layer 100 according to the present invention has no default in being used as the heat radiation material of the corresponding device.

In conclusion, when using the non-conductive frame coated with a conductive layer 100 having a groove 105 or slit 106 formed thereon according to the present invention, over-heating of the wireless transmitting/receiving module 120 may be prevented. Accordingly, this is advantageous in that safety-related accidents, which are caused by such overheating, can be prevented, and that damage caused to the device can also be prevented.

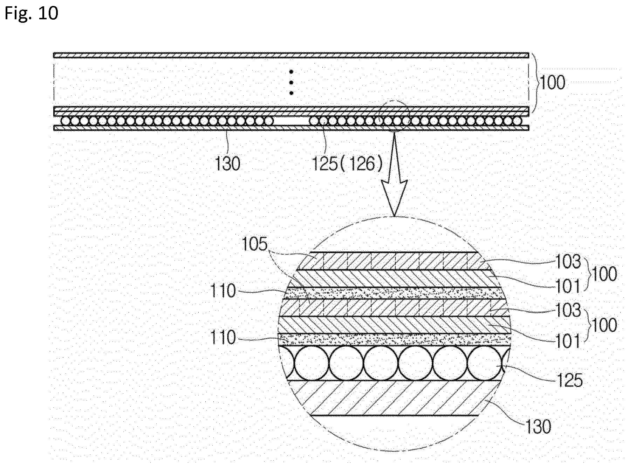

FIG. 10 illustrates that the non-conductive frame coated with a conductive layer 100 is positioned on a receiving unit coil 122, an NFC coil 126, and an MST coil 128, which correspond to the source of heat radiation, as a single layer or in combination with graphite 130.

Meanwhile, the non-conductive frame coated with a conductive layer 100 may be used as a means for transmitting power as well as an antenna for amplifying electromagnetic waves. As shown in FIG. 10, since the non-conductive frame coated with a conductive layer 100 is layered in a multi-layer structure along a transmitting/receiving direction of the NFC module (i.e., the direction along which the electromagnetic waves are transmitted), the multi-layer of non-conductive frames coated with a conductive layer 100 may perform the function of an antenna for amplifying a weak electric field. This has been experimentally verified and configures one of the characteristics of the present invention.

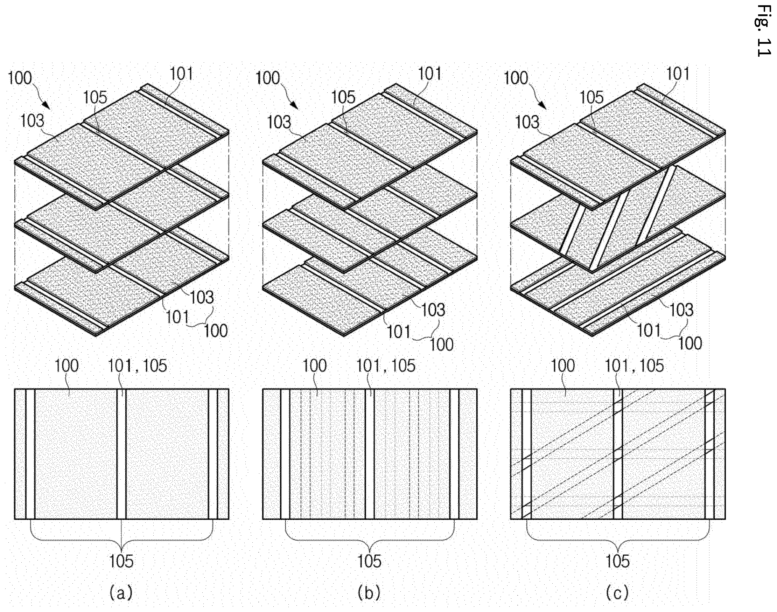

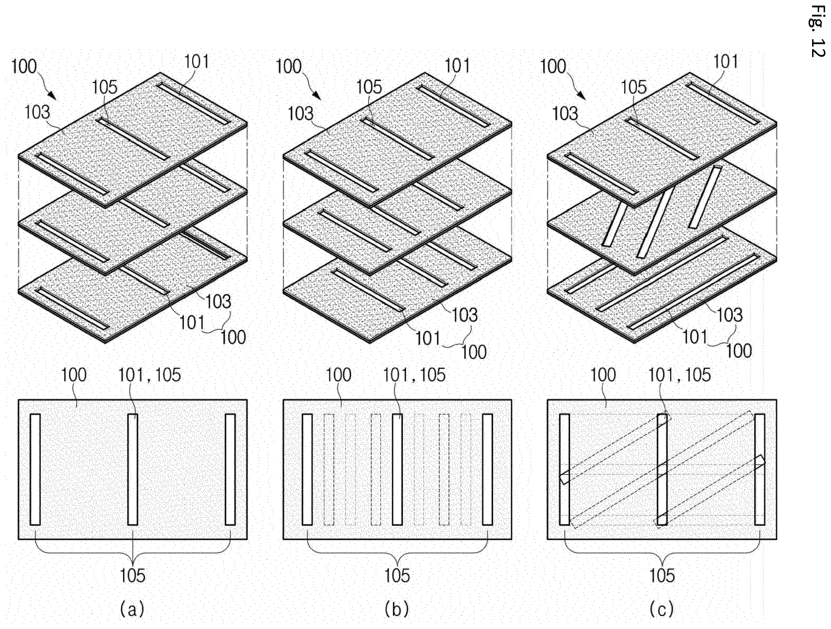

FIG. 11 illustrates a perspective view and a plane view showing a layered status during a process of forming a groove 105 of a non-conductive frame coated with a conductive layer according to a preferred embodiment of the present invention. And, FIG. 12 illustrates a perspective view and a plane view showing a layered status during a process of forming a slit 106 of a non-conductive frame coated with a conductive layer according to a preferred embodiment of the present invention.

As shown in the drawing, a case (a) when the grooves 105 or slits 106 of the non-conductive frame coated with a conductive layer 100 are layered so as to overlap one another at the same positions, a case (b) when the grooves 105 or slits 106 are layered so that they do not overlap with one another at all, and a case (c) when the grooves 105 or slits 106 are layered so that they partially overlap with one another may be implemented.

As described above, the technical spirit and scope of the present invention is significant in that the characteristic of transmitting electromagnetic waves is given to a conductive layer 103 having a general function of blocking electromagnetic waves by providing one or more grooves 105 or one or more grooves 105 and slits 106 on the conductive layer 103 of the non-conductive frame coated with a conductive layer 100 according to the present invention. Accordingly, the industrial applicability of the present invention is recognized in that a metallic material can be directly applied to a device that requires the transmission of electromagnetic waves.

As described above, the non-conductive frame coated with a conductive layer transmitting electromagnetic waves or having a function of heat radiation may have the following advantages. According to the present invention, the non-conductive frame coated with a conductive layer transmitting electromagnetic waves or having a function of heat radiation may be attached to an outer case of diverse devices that is configured of plastic, be equipped inside the device and, most particularly, be capable of enhancing the aesthetic external features of the device by adding a metallic texture when applied to the outer case.

According to the exemplary embodiment of the present invention, the non-conductive frame coated with a conductive layer transmitting electromagnetic waves or having a function of heat radiation may eliminate the function of blocking electromagnetic waves of metal by providing a groove or slit on at least a portion of the conductive layer and that can, therefore, maintain the functions of wireless charging, close-range wireless communication (also referred to as near field communication (NFC)), mobile payment, and so on, which correspond to the unique functions of the device.

According to the exemplary embodiment of the present invention, the non-conductive frame coated with a conductive layer transmitting electromagnetic waves or having a function of heat radiation may maintain its lightweight by maintaining the usage of its outer case, which is configured of plastic.

According to the exemplary embodiment of the present invention, the non-conductive frame coated with a conductive layer transmitting electromagnetic waves or having a function of heat radiation may add diversity in colors that are recognized through the groove or slit formed on the frame, by layering a plurality of frames one over another and by applying different colors to each of the conductive layers and/or conductive frames. Thus, the aesthetic external features of the device may be enhanced.

According to the exemplary embodiment of the present invention, the non-conductive frame coated with a conductive layer transmitting electromagnetic waves or having a function of heat radiation may maximize heat radiation efficiency of the device by using the non-conductive frame coated with a conductive layer as a heat radiation means, wherein the non-conductive frame may be used as a replacement for a graphite heat radiation element, which corresponds to the related art heat radiation means, or wherein the non-conductive frame may be used in combination with the graphite heat radiation element.

According to the exemplary embodiment of the present invention, the non-conductive frame coated with a conductive layer transmitting electromagnetic waves or having a function of heat radiation may enhance the performance of an NFC module and an installation device by amplifying (or increasing) the transmission/reception rate of the NFC module, since the multi-layer structure of the non-conductive frame performs the function of an antenna, in case the non-conductive frame coated with a conductive layer is layered in a multi-layer structure.

It will be apparent to those skilled in the art that various modifications and variations can be made in this specification without departing from the spirit or scope of this specification. Thus, it is intended that this specification covers the modifications and variations of this invention provided they come within the scope of the appended claims and their equivalents. It is also apparent that such variations of this specification are not to be understood individually or separately from the technical scope or spirit of this specification.

## Claims

1. A non-conductive frame coated with a conductive layer transmitting electromagnetic waves or having a function of heat radiation, comprising:
a non-conductive frame functioning as a medium and being used in a device including a wireless electromagnetic wave transmitting module or a wireless electromagnetic wave transmitting or receiving module; and
a conductive layer formed on one surface of the non-conductive frame,
wherein one or more grooves are formed on at least one area of the conductive layer so as to pass through the at least one area in order to allow the non-conductive frame to be exposed, thereby giving a characteristic of electromagnetic wave transmission, and wherein one or more slits are formed on the non-conductive frame along with the groove, and
wherein the non-conductive frame having a conductive layer formed on one surface thereof does not directly contact the wireless electromagnetic wave transmitting module or the wireless electromagnetic wave transmitting or receiving module, and wherein the module is capable of performing electromagnetic wave transmission.

2. The non-conductive frame of claim 1, wherein the frame is formed or processed by using at least of one of 3D printing, laser processing, cutting, and etching, and
wherein the one or more slits are formed or processed by using at least one of 3D printing, sawing, laser processing, punching, and etching.

3. The non-conductive frame of claim 1, wherein the conductive layer is formed by using at least one of 3D printing, plating, coating, printing, vacuum evaporation, and adhesion.

4. The non-conductive frame of claim 1, wherein the non-conductive frame coated with a conductive layer is installed at a position corresponding to a main transmitting direction or a main receiving direction of a transmitting unit or receiving unit of wireless power or wireless charging included in the device.

5. The non-conductive frame of claim 1, wherein a plurality of non-conductive frames coated with a conductive layer are layered in a multi-layer structure on a near field communication (NFC) module included in the device.

6. The non-conductive frame of claim 5, wherein the plurality of non-conductive frames coated with a conductive layer are layered so that positions of the grooves or slits are vertically identical to one another, or that positions of the grooves or slits are alternated.

7. The non-conductive frame of claim 1, wherein a plurality of non-conductive frames coated with a conductive layer are layered one over another, and wherein a color of a lower frame is recognized through one or more grooves or slits of an upper frame.

8. The non-conductive frame of claim 7, wherein a lower conductive layer and an upper conductive layer are configured to have different colors so that the color of the lower conductive layer is recognized through one or more grooves or slits of the upper conductive layer.

9. The non-conductive frame of claim 7, wherein a lower non-conductive frame and an upper non-conductive frame are configured to have different colors so that the color of the lower non-conductive frame is recognized through one or more grooves or slits of the upper non-conductive frame.

10. The non-conductive frame of claim 7, wherein a plurality of non-conductive frames coated with a conductive layer are layered one over another, and wherein an insulating layer is further included between each non-conductive frame, and
wherein the insulating layer corresponds to any one of air, a film, and a coating layer.

11. The non-conductive frame of claim 10, wherein the insulating layer and the upper frame are configured to have different colors so that the color of the insulating layer is recognized through one or more grooves or slits of the upper film.

12. The non-conductive frame of claim 7, wherein, when a plurality of non-conductive frame coated with a conductive layer are layered one over another, patterns of a lower film are configured to not overlap with an upper film, thereby allowing one or more grooves or slits formed on the lower film to be hidden.

13. The non-conductive frame of claim 1, wherein the non-conductive frame coated with a conductive layer is connected to a substrate so as to be applied to a mobile device and used as an antenna.

14. The non-conductive frame of claim 1, wherein an average width of a groove or slit is equal to or less than 2 times an average width between two adjacent grooves or slits.

15. The non-conductive frame of claim 1, wherein the groove or slit has a width exceeding 0 and less than or equal to several millimeters (mm).

16. The non-conductive frame of claim 1, wherein an area where the one or more slits are formed is larger than an area occupied by a wireless transmitting/receiving module for transmitting electromagnetic waves, and wherein an entire area occupied by the wireless transmitting/receiving module is positioned to overlap with at least a portion of the area where the one or more slits are formed.
